# EUROPEAN PATENT APPLICATION

(11) **EP 4 811 569 A1**
(43) Date of publication of application: **23.09.2026**
(21) Application number: 25165486.9
(22) Date of filing: 21.03.2025
(51) Int. Cl.: H01S 5/10, H01S 5/12, H01S 5/065

(54) **SEMICONDUCTOR RING LASER**

(71) Applicant: Sensirion AG, 8712 Stäfa (CH)
(72) Inventor: HILLBRAND, Johannes, 8712 Stäfa (CH); OPACAK, Nikola, 8712 Stäfa (CH); SAUDAN, Quentin, 8712 Stäfa (CH); UEHLINGER, Thomas, 8712 Stäfa (CH); NEUENSCHWANDER, Matthias, 8712 Stäfa (CH); RISQUEZ, Sarah, 8712 Stäfa (CH); JOUY, Pierre, 8712 Stäfa (CH)
(74) Representative: Haines, Miles John L.S.

(57) **Abstract**

A semiconductor ring laser (1) comprising a ring waveguide formed of a ridge (12) of semiconductor material having inner and outer sidewalls (14, 16) and a top surface (18). A mode selecting grating is arranged on at least one of the inner and outer sidewalls (14, 16) to define a ring cavity that supports a radiative and a non-radiative mode, the non-radiative mode having lower losses than the radiative mode so that the non-radiative mode becomes the lasing mode. An output coupler is arranged on at least one of the inner and outer sidewalls (14, 16) and configured such that, local to the output coupler, the non-radiative mode that is the lasing mode is forced into a radiative mode, or a mixed radiative and non-radiative mode, thereby to couple laser light out of the ring waveguide through at least one of the inner and outer sidewalls (14, 16).

## Description

### BACKGROUND OF THE INVENTION

The invention relates to semiconductor ring lasers and to methods of their manufacture.

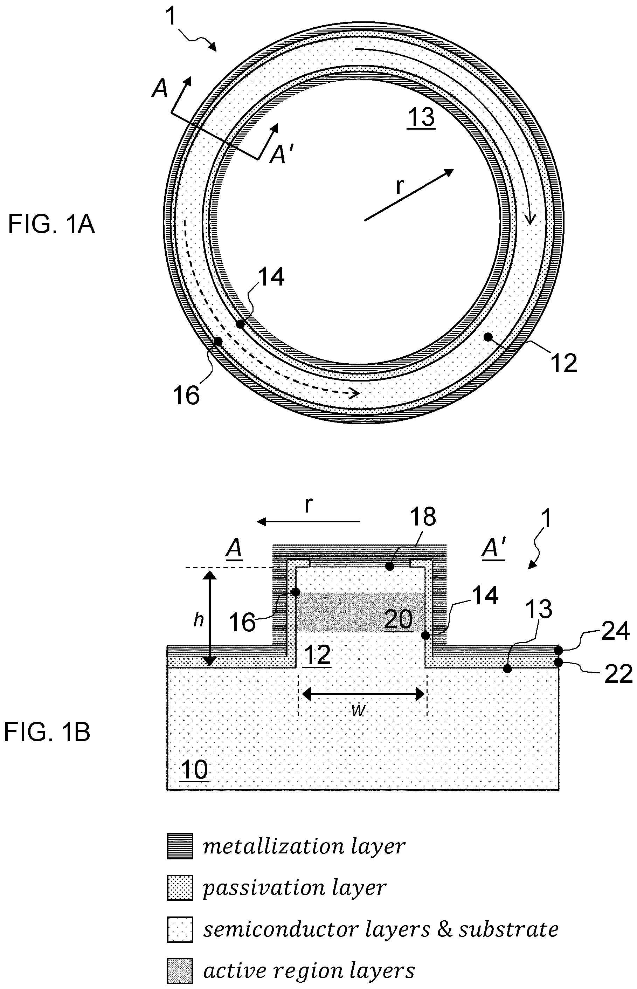

Figures 1A and 1B schematically illustrate a semiconductor ring laser 1 of monolithic construction in plan and cross-section views, where the cross-section is through section A-A' of the plan view. The semiconductor ring laser 1 is based on a semiconductor heterostructure comprising a substrate which has had semiconductor layers 10 epitaxially deposited thereon including active region layers 20, which provide optical gain. The stack of semiconductor layers is in the general form of a separate confinement heterostructure (SCH) with waveguiding layers arranged above and below the active region layers. The optical mode is confined vertically by the waveguiding layers so that it has a significant overlap with the active region layers 20. A ring waveguide is formed in the semiconductor stack by etching a ring-shaped ridge 12 of width, w, and height, h, into the semiconductor surface so that the ridge 12 is elevated above an etched planar surface 13. The ring-shaped ridge 12 has an inner sidewall 14, an outer sidewall 16 and top surface 18. A metal layer 24 is needed to form an electrical contact with the ridge's top surface 18. Before depositing the metal layer 24, a passivation layer 22 of a dielectric material is deposited over the semiconductor surface to cover the inner and outer sidewalls 14, 16 and also adjacent areas of the planar surface 13 but leaving at least a part of the top surface 18 uncovered. A suitable material for the passivation layer 22 is Si₃N₄. A metal layer 24 is then deposited over the exposed top surface 18 as well as the passivation layer 22. The passivation layer 22 thus serves to electrically insulate the semiconductor stack from the metal layer 24 apart from at the top surface 18 where the contact for current injection is formed. As well as serving for current injection into the top of the ridge 12, the metal layer 24 has an important role in carrying heat away from the laser during operation. A grating output coupler is formed on the ridge 12 to act as an output coupler (not shown in Figures 1A & 1B). As described further below, there are various known types of grating. One grating type places the grating on the ridge's top surface 18, as a so-called top grating. Another grating type places the grating on one or both of the sidewalls 14, 16, as a so called lateral or side grating. In this document, the term lateral grating is used.

The electromagnetic modes in a ring waveguide of a semiconductor ring laser are so-called whispering gallery modes (WGMs). WGMs suffer losses from intrinsic loss of the waveguide material, i.e., the materials of the semiconductor layers that overlap the waveguide mode, and from scattering losses at the sidewalls 14, 16 (mostly from the outer sidewall 16). In a ring waveguide, the light propagates in an azimuthal direction, both clockwise (CW) - see Figure 1A solid arrow line - and counterclockwise (CCW) around the closed loop formed by the ring - see Figure 1A dashed arrow - to form a standing wave pattern with nodes and antinodes. The radial direction from the center of the ring is indicated with the solid arrow r. The number of nodes of the electric field along the ring circumference is an integer and called azimuthal mode number *m*₁. The grating can be provided as a Bragg grating which is formed by providing a periodic modulation of the effective refractive index around the ring cavity. The period *p* of a grating is defined by the target wavelength *λ*, the integer grating order *k* and the effective refractive index *n_{eff}* according to: $p = k \frac{λ}{2 ⋅ {n}_{eff}}$

The grating around the ring cavity is also defined by an azimuthal number, which is *m*₂ and represents the total number of grating teeth around the ring cavity. Ring lasers with gratings support bidirectional light propagation that forms a standing wave pattern.

In a second order lateral grating, when both azimuthal numbers are equal, i.e., *m*₁ = *m*₂, the relation between the grating and the standing-wave pattern of the optical mode is described by the phase between them (or the symmetry of the cavity mode with respect to the grating). In this situation, there are two eigenmodes called symmetric and antisymmetric mode (or radiative and non-radiative mode). These modes are spatially shifted to each other by one quarter of the grating period, which is *π*/2 in phase space. For lateral gratings, due to interference reasons, the radiative (symmetric) mode has high scattering loss, so it is outcoupled quite strongly, whereas the non-radiative (anti-symmetric) mode has negligible scattering loss, i.e., near to zero. Since in a cavity of any type, the mode that lases is the one with the lowest losses, and since in a ring cavity it is the non-radiative (anti-symmetric) mode with *m*₁ = *m*₂ that has the lowest losses, this will be the mode that the cavity will select for lasing. However, this mode has almost zero scattering loss, which means that essentially zero light is coupled out of the ring cavity resulting in the laser having a tiny efficiency. This is a known problem; for example, it is discussed in CN105591284A.

A known solution to solve the problem that lateral gratings do not provide effective outcoupling of the lasing non-radiative mode is to fabricate a higher order top grating adjacent the waveguide with a period matched to an integer multiple of the lasing mode period. The higher order top grating provides a scattering mechanism. The higher order top grating can be formed by etching surface corrugations into the top surface of the ring waveguide. In contrast to lateral gratings, both the symmetric and antisymmetric modes in a ring cavity with a top grating have a finite scattering loss. The top grating scatters light out of the ring cavity transverse to the plane of the ring cavity, so light is coupled out upwards through the surface of the chip and/or downwards through the substrate of the chip (which may be thinned to avoid absorption losses).

Some examples of semiconductor ring lasers with top gratings in the published literature are:
- Hedwig Knötig, Borislav Hinkov, Robert Weih, Sven Höfling, Johannes Koeth, Gottfried Strasser; Continuous-wave operation of vertically emitting ring interband cascade lasers at room temperature. Appl. Phys. Lett. 30 March 2020; 116 (13): 131101. https://doi.org/10.1063/1.5139649
- E. Mujagić, S. Schartner, L. K. Hoffmann, W. Schrenk, M. P. Semtsiv, M. Wienold, W. T. Masselink, G. Strasser; Grating-coupled surface emitting quantum cascade ring lasers. *Appl. Phys. Lett.* 7 July 2008; 93 (1): 011108. https://doi.org/10.1063/1.2958910
- EP4329113A1
- CN105591284A (FIGs. 1 to 3 thereof)

There are two significant challenges when fabricating a top grating output coupler on a ring waveguide. Firstly, it is difficult precisely to control the etch depth of the surface corrugations, so that the etch depths of individual laser devices within a batch will vary. This is significant, since the output coupling efficiency of the top grating is strongly dependent on the etch depth due to the exponentially decaying overlap of the grating corrugations with the waveguide mode supported in the ring cavity. Secondly, definition of the ring cavity waveguide and definition of the grating involve two separate lithography steps. Effectively one is attempting to place the grating exactly aligned to the already-formed ring waveguide, so any lateral misalignment will cause performance variations between different laser devices within a batch.

To avoid the fabrication challenges associated with top gratings, it is known instead to form the grating on the inner and/or outer sidewall of the ring waveguide, such a grating being referred to as a lateral grating in contradistinction to a top grating. A lateral grating is formed by etching surface corrugations of the desired period into the inner and/or outer sidewall. These sidewall surface corrugations can be formed in the same lithography step as the ring, thereby solving the alignment problem of top gratings. Moreover, the depth of the surface corrugations is in the plane of the substrate, which is orthogonal to the etch direction, so variation in etch depth does not cause variation in corrugation depth.

Some examples of semiconductor ring lasers with lateral gratings in the published literature are:
- CN104993374A (inner sidewall lateral grating)
- CN104979751A (inner sidewall lateral grating)
- Amir Arbabi, Seyedeh Mahsa Kamali, Ehsan Arbabi, Benjamin G. Griffin, and Lynford L. Goddard, "Grating integrated single mode microring laser," Opt. Express 23, 5335-5347 (2015) https://doi.org/10.1364/OE.23.005335 (inner sidewall lateral grating)
- CN105591284A (outer sidewall lateral grating in FIG. 6 thereof)

In addition, CN105591284A, and also a corresponding journal publication by the same authors:
X. Ma, Q. Chen, Q. Lu, and W. Guo, "A Novel Surface-Emitting Laser based on Microcylinder Cavity Etched with Second-Order Gratings," in Asia Communications and Photonics Conference 2016, OSA Technical Digest (online) (Optica Publishing Group, 2016), paper AF2A.66. disclose a ring laser which combines a top grating and a lateral grating. In this design, the top grating acts as the output coupler (to output vertically) and the lateral grating selects the mode which lases, where the above-mentioned condition *m*₁ = *m*₂ is satisfied by the lateral grating.

CN105591284A therefore discusses three different grating design permutations: only a top grating (FIGs. 1-3), only a lateral grating (FIG. 6); and a combination of a top grating and a lateral grating (FIG. 7). CN105591284A advocates fabricating the output coupling grating with a duty cycle which is small, where duty cycle is the ratio between the length of the unetched part in the grating direction (the unetched part being farthest from the ring cavity), and the grating period. This is because their simulations show that decreasing the duty cycle of the output coupling grating increases the mixing between the symmetric and anti-symmetric WGMs of the ring cavity.

In a realistic semiconductor laser with a lateral grating, small parameter value variations of the waveguide around the ring (e.g., variation in the ridge width, variation in passivation layer thickness, and variation in grating corrugation depth), result in the cavity mode never being perfectly non-radiative, but rather being slightly mixed. A small fraction of the radiative mode is mixed in with the non-radiative mode. For this reason, the efficiency of a realistic semiconductor ring laser with a lateral grating is not zero, but finite although very small. The loss caused by fabrication imperfections is unwanted and of course is not controllable, since its origin is in the lack of control of the processes used during fabrication (e.g., the lithography, the etching, the passivation layer deposition, the metal layer deposition, the ring waveguide sidewalls being not perfectly cylindrical, the thicknesses of the passivation and metal layers not being constant around the ring). Moreover, the metal layer that covers the sidewalls enhances these losses significantly, which results in a significant fraction of the light being lost to the sidewall metal instead of it being coupling out of the ring waveguide into free space. Laser efficiency is therefore reduced significantly.

### SUMMARY OF THE INVENTION

According to one aspect of the invention, there is provided a semiconductor ring laser comprising:
a ring waveguide formed of a ridge of semiconductor material having an inner sidewall and an outer sidewall;
a mode selecting grating arranged on at least one of the inner and outer sidewalls to define a ring cavity that supports a radiative and a non-radiative mode, the non-radiative mode having lower losses than the radiative mode so that the non-radiative mode becomes the lasing mode; and
an output coupler arranged on at least one of the inner and outer sidewalls and configured such that local to the output coupler the non-radiative mode that is the lasing mode is forced into a radiative mode, or a mixed radiative and non-radiative mode, thereby to couple laser light out of the ring waveguide through at least one of the inner and outer sidewalls.

According to this design, it is possible to provide a semiconductor ring laser of monolithic construction based on a lateral grating for mode selection and an output coupler whose outcoupling efficiency is not affected by small process variations. It is therefore possible to mass manufacture semiconductor ring lasers at low cost with high yield.

One kind of semiconductor ring laser according to the invention is a quantum cascade laser (QCL) whose lasing action is based on cascading intraband transitions between subbands of quantum wells in a Type I superlattice structure. QCLs emit in the infrared. Specifically, QCLs have been demonstrated with emission wavelengths from 2.6 µm up to 250 µm. Another kind of semiconductor ring laser according to the invention is an interband cascade laser (ICL) whose lasing action is based on cascading interband transitions between subbands of quantum wells in a Type II (or sometimes Type I) superlattice structure. Another kind of semiconductor ring laser according to the invention is one based on a conventional laser diode (LD) heterostructure, i.e., using an interband transition of a Type I multi-quantum well (MQW) heterostructure. Another kind of semiconductor ring laser according to the invention is a quantum dot laser, e.g. using epitaxially grown semiconductor quantum dots as gain material.

Semiconductor ring lasers according to the invention may be based around the GaAllnAsP or GaAllnN semiconductor materials systems, for example.

The term ring waveguide in the context of the invention includes not only circular rings but also other suitable closed loop shapes that are capable of supporting WGMs, such as ellipses or ovals, or racetrack shapes with two straights connected by two bends.

In certain embodiments, the output coupler is realized as an output coupling grating. Being arranged on one or both of the ridge sidewalls, the output coupler grating is a lateral grating. Therefore, both the mode selection and output coupling are realized by respective lateral gratings which operate in combination to provide their respective functions in which the mode selecting lateral grating ensures that the non-radiative mode becomes the lasing mode and the output coupling grating forces the lasing mode into a radiative mode, or a mixed radiative and non-radiative mode, in the part of the ring local to the output coupling grating.

The mode selecting grating and the output coupling grating may be arranged serially on a common one of the inner and outer sidewalls of the ring waveguide. Alternatively, the mode selecting grating may extend around the whole ring on one sidewall and the output coupling grating over a limited portion of the ring, e.g., defined by azimuthal angle, on the other sidewall. For example, the output coupling grating may extend over an azimuthal angle *ϕ* selected from the group: less than or equal to 90 degrees (*π*/2); less than or equal to 45 degrees (*π*/4); and less than or equal to 30 degrees (*π*/6). Other permutations for the relative lengths and sidewall placements of the mode selecting grating and the output coupling grating are possible.

In one specific design, the output coupling grating and the mode selecting grating have a common period and respective first and second azimuthal mode numbers, denoted *m*₁, *m*₂, that are equal, and wherein the output coupling grating and the mode selecting grating have a phase offset. In this design, the phase offset may be selected to approximate to a quarter of the common period, i.e., 90 degrees (*π*/2), in a range selected from the group:
90±80 degrees;
90±70 degrees;
90±60 degrees;
90±50 degrees;
90±40 degrees; and
90±30 degrees.

In another specific design, the mode selecting grating and the output coupling grating have respective first and second periods that are different from one another as well as respective first and second azimuthal mode numbers, denoted *m*₁, *m*₂, that are different from one another. In this design, the output coupling grating may be configured to extend over an angle *ϕ* that is related to the difference between the first and second azimuthal mode numbers, denoted Δ*m* = |*m*₁ - *m*₂|, such that the product Δ*m* · *ϕ* is selected from the group: greater than or equal to 360 degrees (2*π*); greater than or equal to 180 degrees (*π*); and greater than or equal to 90 degrees (*π*/2).

In yet another specific design, the mode selecting grating and the output coupling grating are arranged on different ones of the inner and outer sidewalls of the ring waveguide.

In a still further specific design, the mode selecting grating is arranged on the inner sidewall and the outer sidewall and the output coupling grating is arranged on at least one of the inner and outer sidewalls, and wherein the mode selecting grating and the output coupling grating are arranged serially around the ring waveguide.

According to alternative embodiments, instead of realizing the output coupler with a grating, the output coupler is realized with a point scatterer, such as a notch.

There are different options for metallizing the ridge sidewalls. Depending on the embodiment, one sidewall may be metallized but not the other, both sidewalls may be metallized, or neither sidewall is metallized. The choice of sidewall metallization affects how the laser light is outcoupled and whether or not a lateral optical cavity is formed by the waveguide.

In embodiments with one-sided metallization of the ridge, the semiconductor ring laser further comprises a metal layer arranged to cover the top surface of the ridge where it forms an ohmic contact, the metal layer being further arranged to cover one and only one of the inner and outer sidewalls thereby providing a metallized sidewall and an unmetallized sidewall. A one-sided metallization avoids the metal layer forming a lateral optical cavity between the inner and outer sidewalls. With a one-sided metallization of the ridge, the ring waveguide width is advantageously selected for optimum laser output power by ensuring that the phase delay accumulated between laser light coupled out of the ring waveguide through the unmetallized sidewall indirectly via reflection from the metallized sidewall and laser light coupled out of the ring waveguide through the unmetallized sidewall directly without reflection from the metallized sidewall are in phase and hence constructively interfere with each other. This may be defined by the phase delay being approximately 2*π* · *k,* e.g., in a range selected from the group: $2 π ⋅ \left(k\pm \frac{1}{3}\right) ;$ $2 π ⋅ \left(k\pm \frac{1}{4}\right) ;$ and $2 π ⋅ \left(k\pm \frac{1}{6}\right) ,$ where k is a positive integer. This provides good laser output power by ensuring that laser light contributions coupled out directly and indirectly via said reflection constructively interfere with each other.

In implementations of one-sided metallization where the metal layer covers the inner sidewall, a layer of dielectric material may be interposed between the inner sidewall and the metal layer. In one example of one-sided metallization, the outer sidewall is covered with a layer of the dielectric material, which is in turn exposed to air, and wherein the mode selecting grating and the output coupling grating are arranged on at least the outer sidewall. In another example of one-sided metallization, the outer sidewall is covered with a layer of the dielectric material, which is in turn exposed to air, and wherein the mode selecting grating and the output coupling grating are arranged at least on the inner sidewall. In a still further example of one-sided metallization, the outer sidewall is adjacent a trench that separates the top surface of the ridge from a further radially outwardly adjacent top surface, wherein the metal layer covers the top surface of the ridge and the further radially outwardly adjacent top surface but is excluded from the trench by the dielectric material.

In embodiments with two-sided metallization of the ridge, the semiconductor ring laser further comprises a metal layer arranged to cover the top surface of the ridge where it forms an ohmic contact, the metal layer being further arranged to cover both the inner and outer sidewalls, so that the metal layer forms a lateral optical cavity between the inner and outer sidewalls, and wherein the ring waveguide has a width selected such that the phase delay accumulated by laser light scattered by the output coupler and reflected from the inner and outer sidewalls is away from resonance with a mode of the lateral optical cavity. The anti-resonant condition may be defined by the phase delay being approximately 2*π* · *k +* 1/2, e.g., in a range selected from the group: $2 π ⋅ \left(k+\frac{1}{2}\pm \frac{1}{3}\right) ;$ $2 π ⋅ \left(k+\frac{1}{2}\pm \frac{1}{4}\right) ;$ and $2 π ⋅ \left(k+\frac{1}{2}\pm \frac{1}{6}\right) ,$ where *k* is a positive integer. It can thereby be avoided that the lasing mode resonates with a mode of the lateral optical cavity.

In embodiments without metallization on either sidewall of the ridge, the semiconductor ring laser further comprises a metal layer arranged to cover the top surface of the ridge where it forms an ohmic contact but not to cover either the inner or the outer sidewall. Absent metal on either sidewall, no lateral optical cavity is formed between them. One example design that avoids metallization of the sidewalls is realized by a planarizing layer of insulating material that buries the inner and outer sidewalls while leaving exposed at least a portion of the top surface for forming the ohmic contact. The metal layer is then arranged on top of the planarizing layer radially adjacent to the top surface, thereby avoiding that the metal layer covers either the inner sidewall or the outer sidewall.

According to another aspect of the invention, there is provided a method of manufacturing a semiconductor ring laser, the method comprising:
fabricating a semiconductor heterostructure by:
   i. providing a substrate;
   ii. depositing lower semiconductor layers including at least one lower waveguiding layer;
   iii. depositing active region layers by alternating deposition of first and second semiconductor materials having different values of band gap energy to form a multi-quantum well structure or a superlattice; and
   iv. depositing upper semiconductor layers including at least one upper waveguiding layer;
performing an etch to create a ring waveguide by removing selected areas of the semiconductor heterostructure to a depth extending through the upper semiconductor layers and the active region layers to form a ridge having an inner sidewall, an outer sidewall and a top surface,
wherein the etch also creates corrugations in at least one of the inner and outer sidewalls, the corrugations creating a mode selecting grating to define a ring cavity that supports a radiative and a non-radiative mode, the non-radiative mode having lower losses than the radiative mode so that the non-radiative mode becomes the lasing mode, and
wherein the etch also creates an output coupler arranged laterally on at least one of the inner and outer sidewalls such that local to the output coupler the non-radiative mode that is the lasing mode is forced into a radiative mode, or a mixed radiative and non-radiative mode, thereby to couple laser light out of the ring waveguide through at least one of the inner and outer sidewalls.

In certain embodiments, the method may be carried out such that the etch also creates further corrugations in at least one of the inner and outer sidewalls, the further corrugations creating the output coupler as an output coupling grating. In alternative embodiments, the method may be carried out such that the etch also creates a notch in at least one of the inner and outer sidewalls, the notch creating the output coupler as a point scatterer.

The above method may include, after performing said etch, depositing a passivation layer to cover the ridge; removing an area of the passivation layer to expose at least a portion of the top surface; and depositing a metallization layer over the ridge to form an ohmic electrical contact with the top surface.

In one specific design, one or both of the inner and outer sidewalls is formed during the etch by etching a trench in the semiconductor heterostructure.

Moreover, to realize embodiments which avoid metallization of the ridge sidewalls, before depositing the metallization layer, an insulating layer may be deposited over the passivation layer to bury all but the top surface of the ridge. The metal layer subsequently deposited then spreads over at least some of the top surface of the ridge and the top of the insulating layer.

### BRIEF DESCRIPTION OF THE DRAWINGS

This invention will now be further described, by way of example only, with reference to the accompanying drawings.
Figures 1A and 1B are schematic plan and cross-sectional views of a semiconductor ring laser with standard architecture according to the prior art.

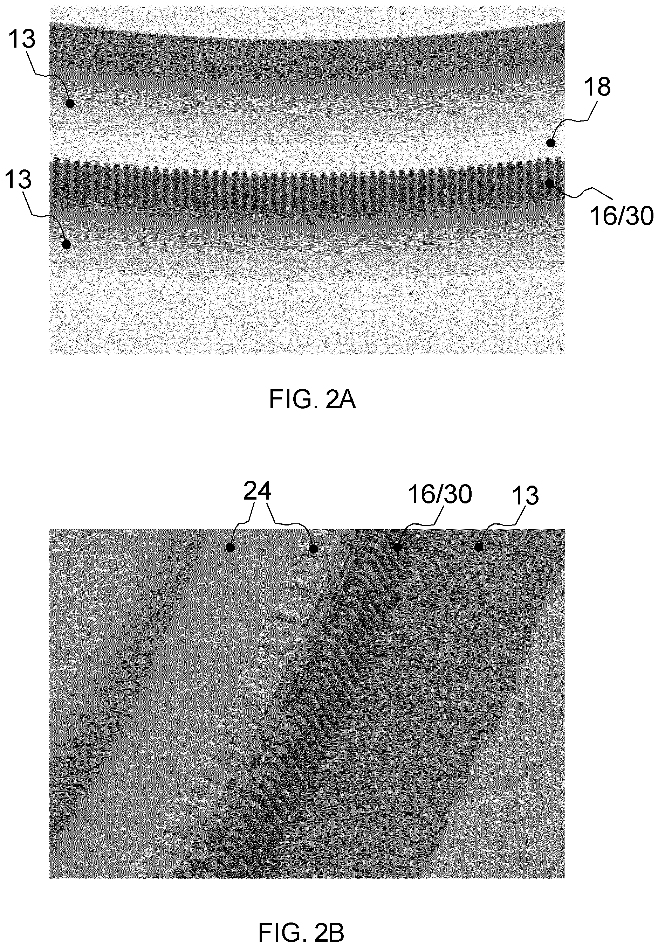

Figure 2A is an image taken with a scanning electron microscope (SEM) of an angular portion of a semiconductor ring laser according to a first embodiment of the invention at an intermediate stage during its fabrication.
Figure 2B is an SEM image of an angular portion of a semiconductor ring laser according to a first embodiment of the invention at a later intermediate stage of fabrication compared to Figure 2A.

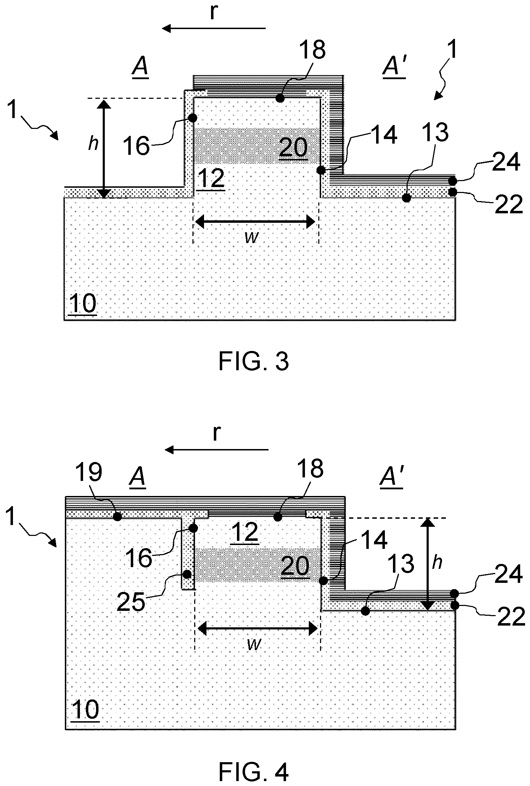

Figure 3 is a schematic cross-section through a semiconductor ring laser according to the first embodiment.
Figure 4 is a schematic cross-section through a semiconductor ring laser according to a further embodiment.

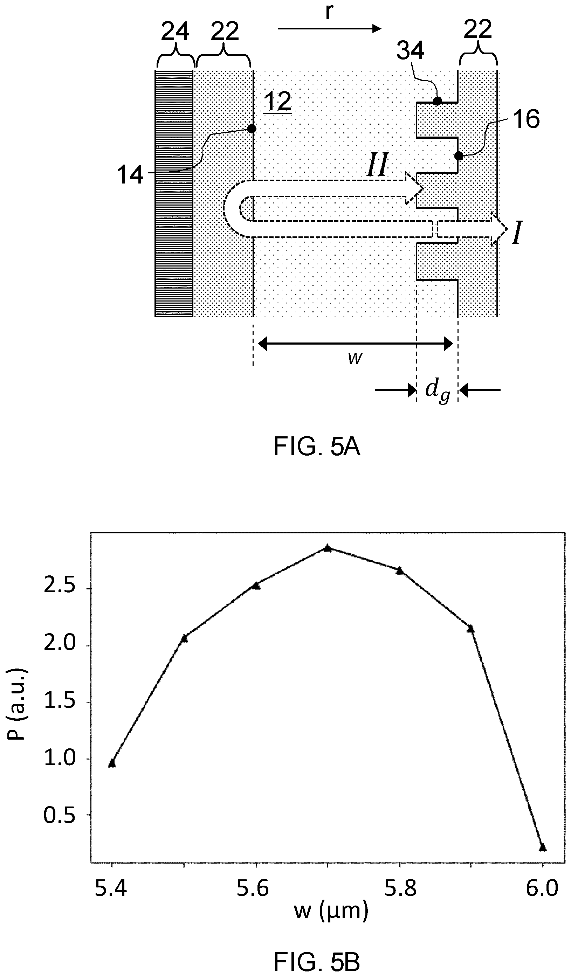

Figure 5A is a schematic drawing showing outcoupling in embodiments of the invention such as shown in Figures 3 and 4.
Figure 5B is a graph plotting emitted power, P, in arbitrary units as a function of waveguide width, w, in micrometers, µm, for embodiments of the invention such as shown in Figures 3 and 4.

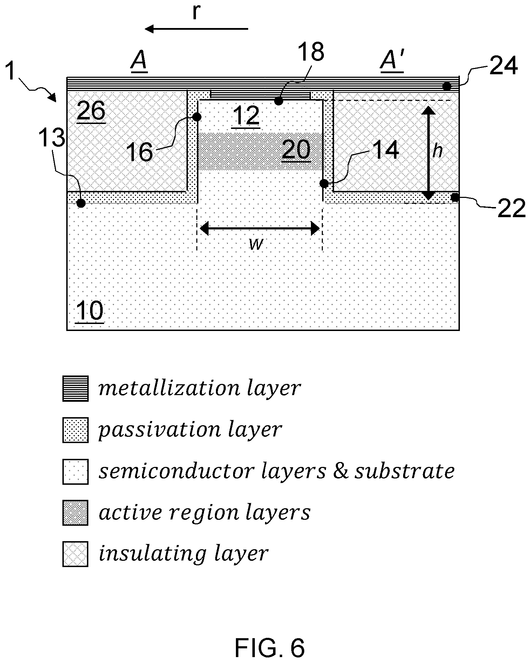

Figure 6 is a schematic cross-section through a semiconductor ring laser according to a still further embodiment.

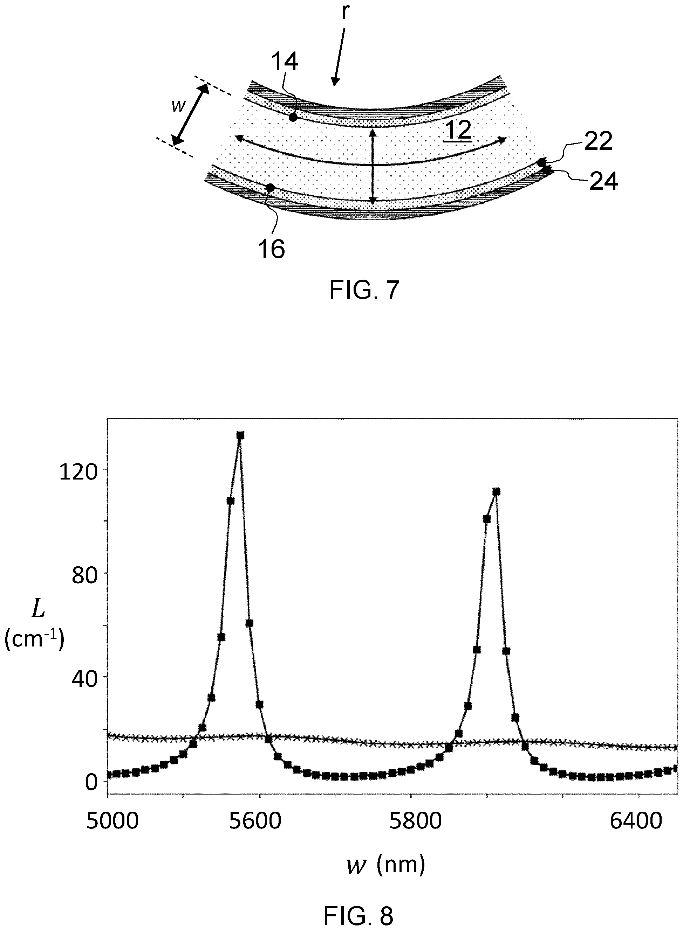

Figure 7 is a schematic drawing showing an arcuate portion of a conventional semiconductor ring laser in plan view, similar to Figure 1A.
Figure 8 is a graph showing simulation results of cavity losses, L, of the radiative mode in units of *cm*⁻¹ as a function of waveguide width, w, in units of *nm* for two example structures with double-sided metallization of the ring waveguide as shown in Figures 1A and 1B and also Figure 7.

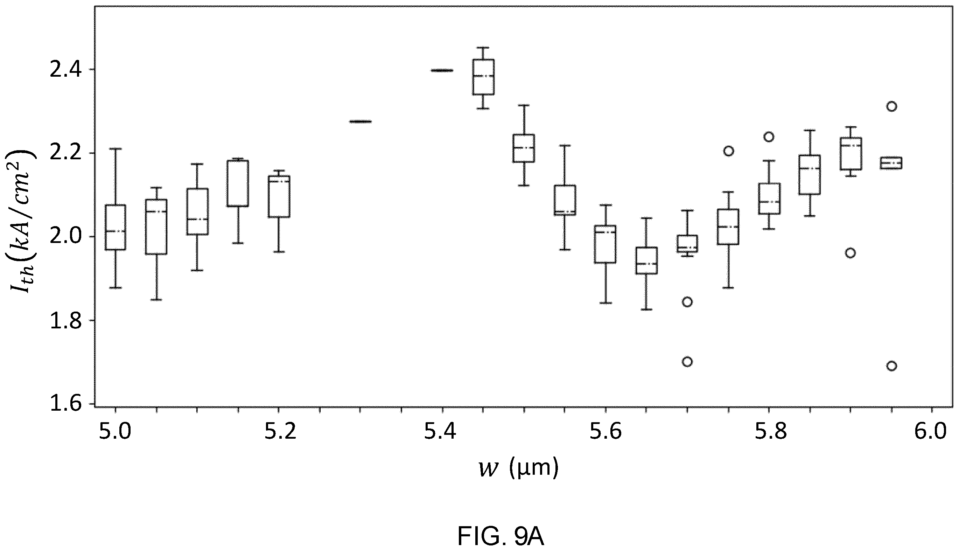

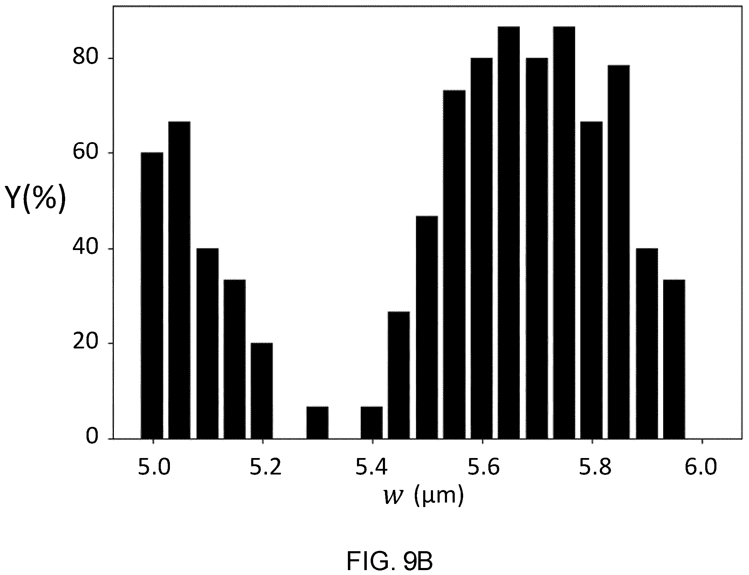

Figures 9A and 9B show device performance characteristics of example semiconductor ring lasers with metallization of both inner and outer sidewalls.

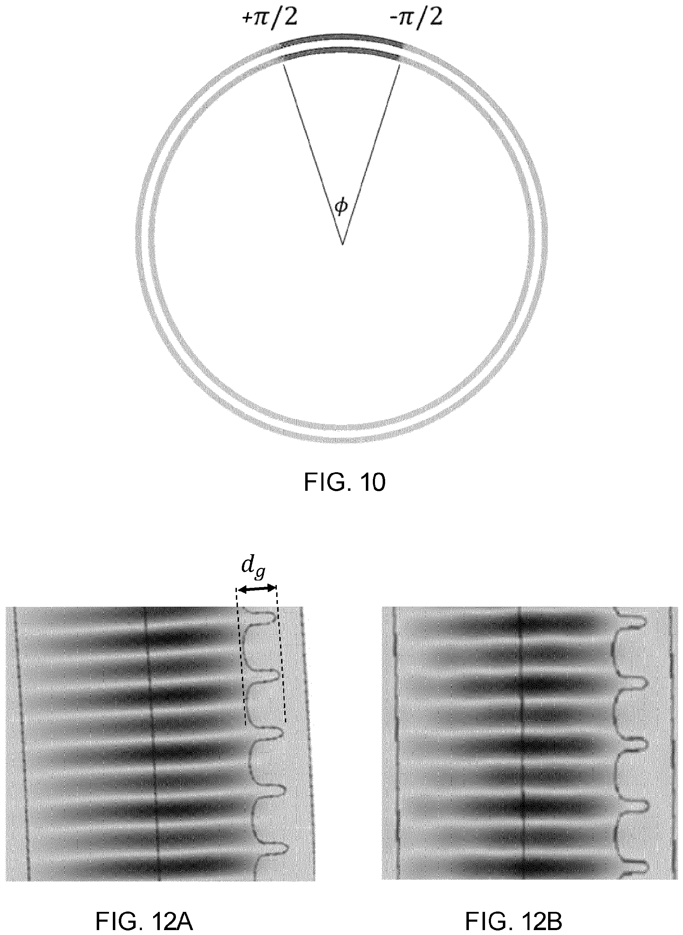

Figure 10 is a schematic drawing of one example of how the lateral grating can be phase shifted to form an output coupler.

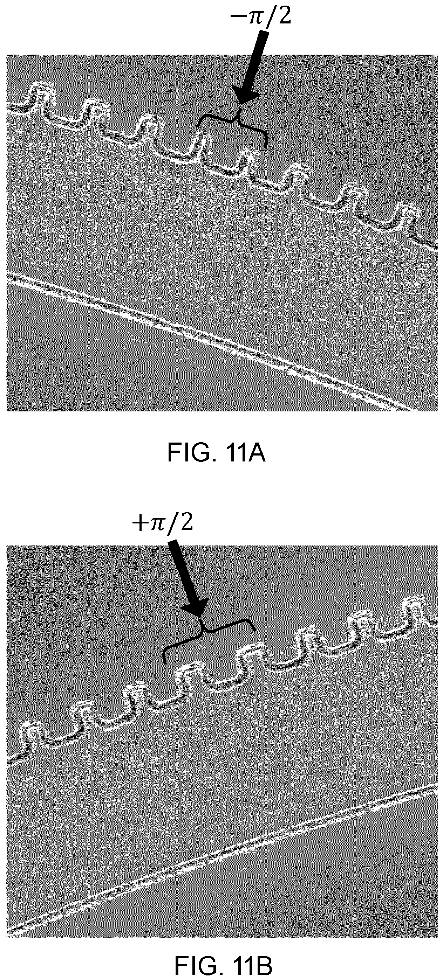

Figures 11A and 11B are SEM images showing an example of positive and negative *π*/2 phase shifts which are distributed over two grating teeth.
Figures 12A and 12B show simulation results illustrating how the radiative and non-radiative modes are spatially shifted with respect to the grating teeth by a quarter of the grating period.

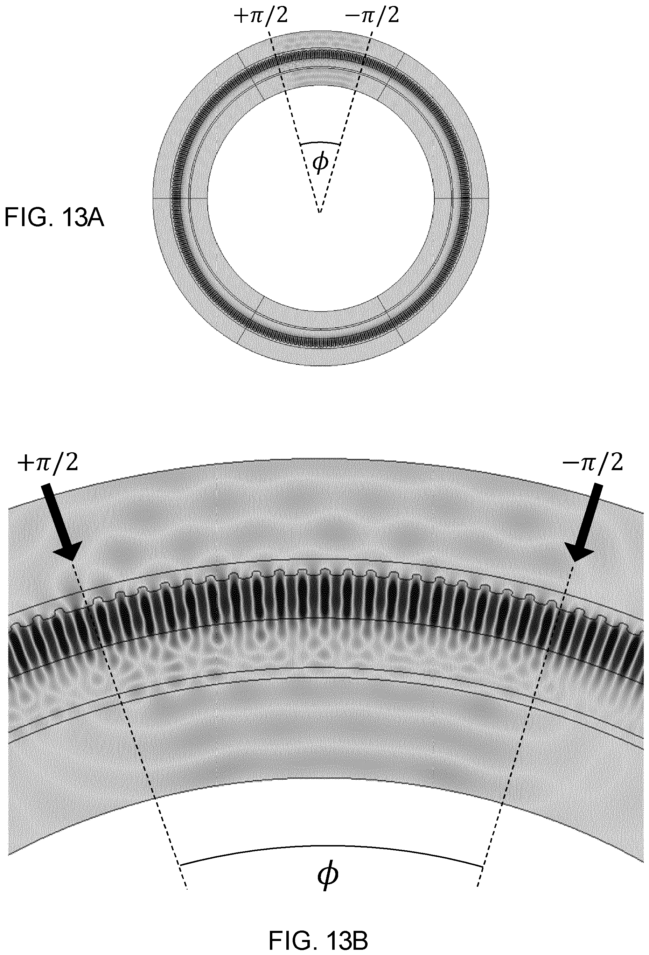

Figure 13A is a plan view showing the light fields for a semiconductor ring laser as illustrated in Figure 10 as calculated by a numerical simulation, and Figure 13B is an enlarged view of Figure 13A.

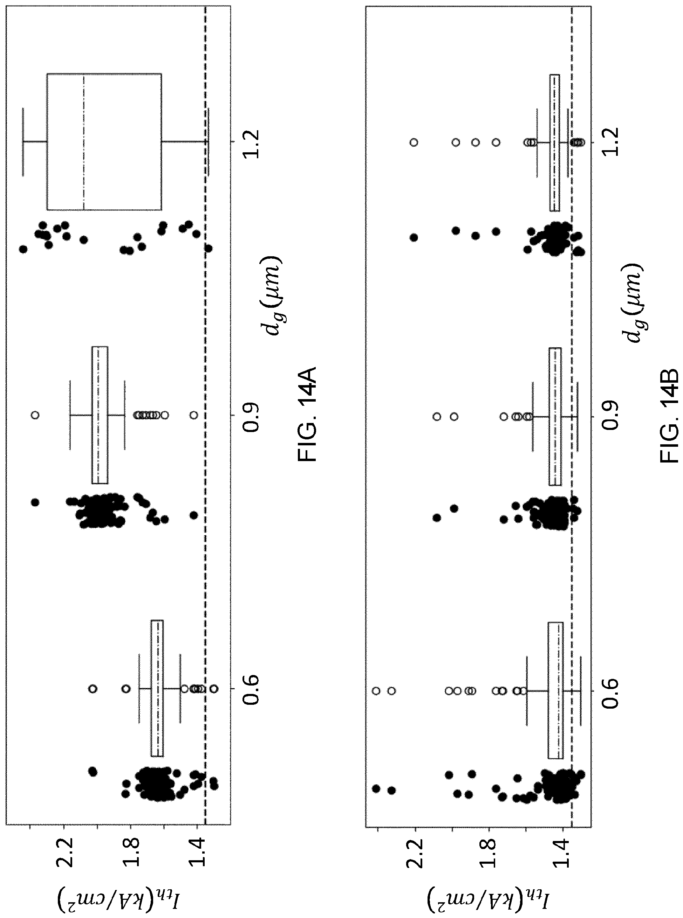

Figure 14A is a graph plotting threshold current density *Iₜₕ* in units of *kA*/*cm*² for example lasers manufactured at each of the three corrugation depths, these lasers being made with double-sided metallization of the ring waveguide ridge.
Figure 14B is a graph to be compared with Figure 14A plotting threshold current density *Iₜₕ* in units of *kA*/*cm*² for example lasers manufactured at each of the three corrugation depths, these lasers being made with single-sided metallization of the ring waveguide ridge.

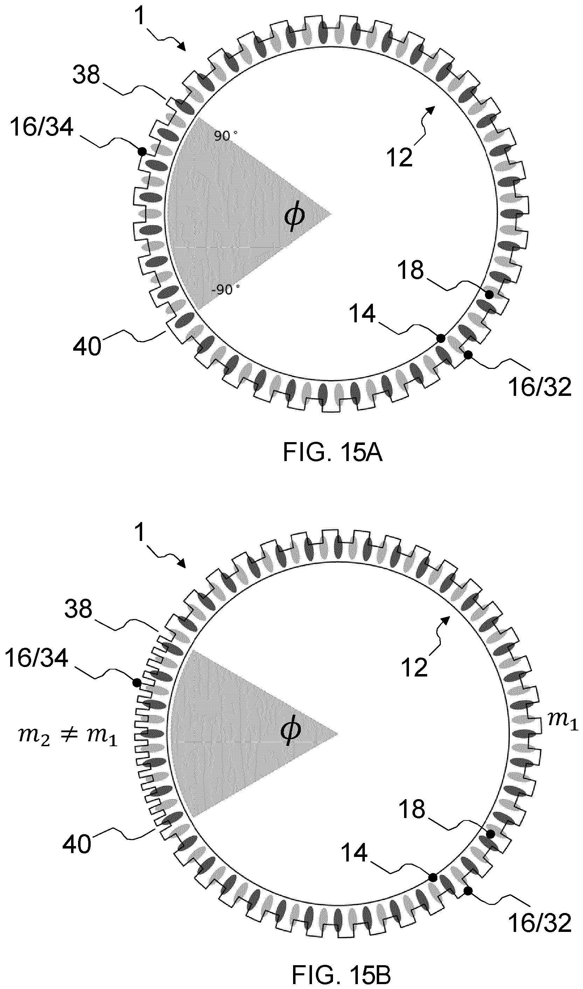

Figures 15A to 15D are schematic plan views of example semiconductor ring lasers according to different embodiments of the invention.

### DETAILED DESCRIPTION

Figure 2A is an image taken with a scanning electron microscope (SEM) of an angular portion of a semiconductor ring laser according to a first embodiment of the invention at an intermediate stage during its fabrication. At the illustrated stage in fabrication, the ring waveguide has been formed by etching and, during the same etch step, a lateral grating 30 has been formed on the outer sidewall 16.

Figure 2B is an SEM image of an angular portion of a semiconductor ring laser according to a first embodiment of the invention at a later intermediate stage of fabrication compared to Figure 2A. This is the stage after finishing the cleanroom process, i.e. before device singulation. A passivation layer (not visible) and then a metal layer 24 have been deposited onto the etched ring shown in Figure 2A leaving the grating-bearing outer sidewall 16 free of metal. The metal layer 24 covers the ridge's top surface 18, the inner sidewall 14 and an area of the planar surface 13 radially inside the ring waveguide.

Figure 3 is a schematic diagram of a cross-section of a semiconductor ring laser 1 according to the first embodiment, as already shown in Figures 2A & 2B. Figure 3 is in an analogous format to Figure 1B for ease of comparison. The semiconductor ring laser 1 is based on a semiconductor heterostructure comprising a substrate which has had semiconductor layers 10 epitaxially deposited thereon including active region layers 20. The stack of semiconductor layers is in the general form of a separate confinement heterostructure (SCH) with waveguiding layers arranged above and below the active region layers. The active region for forming the ring laser can follow any known design such as by way of example an interband MQW LD, a QCL, an ICL or a quantum dot laser. For this reason, the precise layer sequence of the active region has not been described in detail. For a QCL, the most common designs are bound-to-bound, bound-to-continuum and continuum-to-continuum, any of which is suitable for embodiments of the invention. The optical mode is confined vertically by the waveguiding layers so that it has a significant overlap with the active region layers 20. A ring waveguide is formed in the semiconductor stack by etching a ring-shaped ridge 12 of width, w, and height, h, into the semiconductor surface so that the ridge 12 is elevated above an etched planar surface 13. The ring-shaped ridge 12 has an inner sidewall 14, an outer sidewall 16 and top surface 18. A metal layer 24 is needed to form an ohmic contact with the ridge's top surface 18. Before depositing the metal layer 24, a passivation layer 22 of a dielectric material is deposited over the semiconductor surface including the ridge 12. The dielectric material is then removed from an area of the ridge top surface 18 with a reactive ion etching (RIE) step. A suitable material for the passivation layer 22 is Si₃N₄. Other suitable materials for the passivation layer 22 are Al₂O₃, SiO₂, and MgO. A metal layer (or layer combination) 24 is then deposited over the exposed top surface 18 as well as the radially inner part of the passivation layer 22. In fact, the metal layer may be deposited over all areas and then removed by a lift-off process from the outer sidewall 16. The passivation layer 22 thus serves to electrically insulate the semiconductor stack from the metal layer 24 apart from at the top surface 18 where the contact for current injection is formed. The metal layer 24 provides a top electrical contact, more specifically an ohmic contact. A bottom ohmic contact (not shown) is also formed, so that the top and bottom contacts together provide for carrier injection vertically across the active region layers 20. For example, the top contact can be formed first by depositing a first metal layer (for example with Ti, Pt, Au or an alloy therebetween) on the top surface 18 of the ridge 12 and then by depositing a second metal layer (for example by electroplating with Au) on top of that with these two metallization processes collectively forming the metal layer 24. The metal layer 24 not only has the electrical function of providing the top ohmic electrical contact but also has a thermal function to provide for heat extraction of the heat generated in the ring waveguide by the lasing action. The top contact layer between the top of the semiconductor stack and the electroplated thicker metal layer is provided for good adhesion and materials' compatibility. The bottom (or base) contact (not illustrated) is formed on the bottom surface of the substrate or an exposed part of the planar surface 13 that is well away from the ridge 12 using metallization, for example with a material or material combination selected from Ge/Au/Ni/Au or an alloy therebetween.

A higher order lateral grating (not shown) is applied to the outer or inner sidewall of the annular waveguide or on both sidewalls, the grating having a period $p = k ⋅ \frac{λ}{2 ⋅ {n}_{eff}}$ with k being an integer larger than 1. The waveguide and grating can be formed in the same etching step. Alternatively, the waveguide and grating could be formed in separate etch steps. In the following, the case of the lateral grating being formed on the outer sidewall is pursued.

There are two notable design features of the ring laser of the first embodiment according to Figure 3. First, there is the fact that the metal layer is absent from the outer sidewall as mentioned above. Second, what has not yet been mentioned, is that the lateral grating is phase shifted over a length portion of the ring to induce outcoupling laterally from the ring in that length portion. These two design features are now discussed in turn.

### Avoidance of double-sided metallization

In the first embodiment, the metal layer is absent from the outer sidewall. A more general formulation of this feature is that the metal layer is arranged so that it does not bound the waveguide on both sides.

It is also noted that, while Figure 2B shows the lateral grating being free of the metal layer, in other embodiments, the lateral grating could be buried by the metal layer, for example by modifying the structure of Figure 2B to move the lateral grating to the inner sidewall 14 or by modifying the structure of Figure 2B to deposit the metal onto the outer sidewall and leave the inner sidewall free of metal. In still further embodiments, both inner and outer sidewalls could have lateral grating corrugations, and the metal layer could be deposited so as to leave one or both of the inner or outer sidewall free of metal. Some specific options for variation are now described with reference to Figures 5 & 6.

Figure 4 shows a cross-section of the ring according to another embodiment in which the metal layer 24 covers the inner sidewall 14 but not the outer sidewall 16. In this embodiment, before depositing the passivation layer 22, a narrow trench 25 is etched down into the semiconductor stack to form the outer sidewall 16 of the ridge 12 whereas the inner sidewall 14 is formed as in the embodiment of Figure 3 by a large area etch. The etch to form the trench 25 also forms the surface corrugations of the lateral grating (not shown). The top of the trench 25 is bounded on the radially inner side by the ridge top surface 18 and on the radially outer side by an elevated surface 19 that like the top surface 18 has not been etched and so is coplanar therewith. The passivation layer 22 is then deposited to cover the elevated surface 19 radially outward of the trench 25, the ridge inner sidewall 14 and the etched planar layer 13. The passivation layer material also fills the trench 25, or at least blocks the top of the trench, so that subsequent metal deposition of metal layer 24 excludes metal from entering the trench 25.

Figures 3 and 4 are examples of designs that have single-sided (or one-sided) metallization of the ridge. With one-sided metallization, there are two components of light that are coupled out from the waveguide by the output coupler.

Figure 5A is a schematic drawing of this effect which is now described by way of example in the case that the unmetallized sidewall is the radially outwardly facing sidewall 16 and also bears the lateral output coupling grating 34. There is a first component, *I*, of outcoupled laser light, arising from the output coupling grating 34 causing radially outward scattering, in which case the scattered light exits the waveguide formed by the ridge 12 and passivation layer 22 directly. There is also a second component, *II,* arising from the output coupler causing radially inward scattering, in which case the scattered light is reflected from the metallized sidewall 14 before exiting the waveguide through the unmetallized sidewall 16. Maximum outcoupling efficiency is achieved when these two components are in phase with each other, so that both components interfere constructively, i.e. accumulate a phase difference between each other of 2*π* · *k,* where *k* is a positive integer. The phase difference is selected by appropriate specification of the waveguide width, w, which is defined by the ridge width, the passivation layer thickness and the corrugation depth, *d_{g}* , of the lateral output coupling grating 34.

Figure 5B is a graph plotting emitted power, P, in arbitrary units as a function of waveguide width, *w*, in micrometers, µm, for an example design with one-sided metallization showing how output power falls off when the phase difference between the two output components increases. The in-phase condition is met at a waveguide width of 5.7 µm, where maximum output power is observed, and the output power gradually decreases as the phases of the two output components become increasingly mismatched and start to destructively interfere.

Figure 6 shows a cross-section of the ring according to a still further embodiment in which the metal layer 24 covers neither the inner sidewall 14 nor the outer sidewall 16. This is achieved as follows. After deposition of the passivation layer 22, the surface 13 and ridge 12 are planarized by deposition of an electrically insulating material, such as a polymer, to bury all but the top surface of the ridge. The sidewalls 14, 16 of the ridge are thus buried while leaving the ridge top surface 18 exposed on a planar top surface. Suitable polymers include benzocyclobutene (BCB), SU-8 photoresist, cyclic olefin copolymer, and polymethyl methacrylate (PMMA).

The metallization then proceeds to form the top contact, with the metal layer being kept away from the ridge sidewalls 14, 16 by the planarizing layer 26.

The reason why it is advantageous to follow the design approach of avoiding metallizing both of the sidewalls 14, 16 as exemplified by Figures 4 to 6, is now discussed.

Figure 7 is a schematic drawing showing an arcuate portion of a conventional ring laser in plan view, similar to Figure 1A. The ridge has metallization on the inner and outer sidewalls. The metallized sidewalls are reflective to light propagating in the ring waveguide, resulting in the sidewalls forming a cavity in the radial direction of the ring, with a cavity length set by the width of the ridge and the thickness of the passivation layer. The ring waveguide will thus support unwanted radial modes in addition to the desired longitudinal modes around the ring, as indicated schematically by the radially and azimuthally extending arrowed lines.

Figure 8 is a graph showing simulation results of cavity losses, L, of the radiative mode in units of *cm*⁻¹ as a function of waveguide width, w, in units of *nm* for two simulated cases. The strongly peaked curve with square points shows how varying waveguide width (e.g. by changing ridge width) affects cavity losses when both sidewalls are coated with metals. There are two pronounced peaks with losses of over 100 *cm*⁻¹ shows the radiative mode losses when the inner and outer sidewalls are both covered with metal and hence form a lateral optical cavity that couples with light scattered from the lateral grating (Figure 1B situation). The flatter curve with the cross points is a corresponding simulation but with both sidewalls free from metals. As a result, there is no lateral cavity formed and there are no strong resonances in the radiative mode losses (Figure 6 situation). Comparing the two curves, it is evident that the lateral cavity causes large losses for light propagating in the waveguide whenever the lateral cavity resonance wavelength approximates to the lasing wavelength, since the waveguide losses are resonantly enhanced by the lateral cavity. The coupling to the lateral cavity is induced by light scattered by the grating which couples to the lateral cavity if the resonance condition is met, i.e., if the phase delay of the light from traversing the waveguide laterally once is equal to an integer multiple of 2*π*. This light is then lost by absorption of the metal on the sidewall. Resonance with the lateral cavity thus resonantly enhances the losses that arise from small process variations which lead to partial lasing in the symmetric mode. The unwanted losses caused by imperfections channeling small amounts of power into the symmetric mode are strongly influenced by many parameters. Among the most important ones are variations in any of the following: waveguide width (which scales with ridge width), grating depth (i.e., corrugation depth for a lateral grating), and thickness of the passivation layer on the sidewalls. Since the amount of power transferred to the symmetric mode depends on these uncontrolled process variations, the magnitude of these losses in any given individual device is uncontrollable, i.e., they randomly vary in magnitude from device to device. It is therefore these inherently uncontrollable losses that are being resonantly enhanced by scattering from the grating coupling to the lateral cavity. In the simulation of Figure 8, even if 5% of the cavity mode power were lasing in the radiative mode owing to process imperfections, this would result in unwanted losses of more than 5 *cm*⁻¹*.*

It can thus be understood why metallizing in such a way as to avoid forming a lateral optical cavity will suppress formation of unwanted radial modes and avoid the possibility of making a device which resonantly enhances the uncontrollable losses caused by fabrication imperfections channeling small amounts of power into the radiative mode. This is important from a yield perspective, since as mentioned above, not all the process parameters are under perfect control, so removing the possibility of such resonant enhancement of these uncontrolled losses relaxes the parameter space in which highly efficient lasers are produced and reduces the statistical spread of losses within any given manufactured batch.

**Alternative to elimination of lateral optical cavity formation:** An alternative solution for fabricating ring lasers so they are less sensitive to fabrication imperfections becomes clear once one has an appreciation of the radial mode problem. Namely, metallization of both the inner and outer sidewalls can be tolerated provided that parameters that define the lateral cavity length (principally ridge width, passivation layer thickness on the sidewalls, and lateral grating corrugation depth) are selected in combination with other relevant parameters, so that the laser operates well away from the peak losses where the lateral cavity resonates with the radiative mode at the lasing wavelength. The resonance condition to be avoided is when the phase delay accumulated at the laser wavelength when the light propagates laterally across the waveguide twice, i.e. back and forth once, is equal to $2 π ⋅ k$ where k is a positive integer. By the same token, the precisely off-resonance condition is at $2 π \left(k+\frac{1}{2}\right)$

With reference to Figure 8, it can be seen that exact compliance with the off-resonance condition is not necessary. Rather, resonance is avoided over quite a large range, as shown in the figure by the range over which the radiative mode losses of the peaked curve are lower than those of the radiative mode losses for the flatter curve. However, in practice this is a more complicated approach to realize than simply avoiding metallizing both sidewalls, since it relies on good control of the fabrication processes to avoid any of the devices being close to resonance.

Figures 9A and 9B show device performance characteristics of a batch of example semiconductor ring laser devices fabricated with metallization of both inner and outer sidewalls. The waveguide width of this batch of example semiconductor ring laser devices was varied over more than a full period of the lateral cavity resonance.

Figure 9A is a box plot of threshold current density *Iₜₕ* in units of *kA*/*cm*² against waveguide width w in micrometers. The best performing devices, i.e., the ones with the lowest threshold current densities, are centered around waveguide widths at approximately 5.0 µm and 5.6 µm, corresponding to where the waveguide widths are farthest away from the resonance condition. On the other hand, the worst performing devices, i.e., the ones with the highest threshold current densities or the ones that did not lase at all, are centered around waveguide widths at approximately 5.3 µm, corresponding to where the waveguide widths are closest to the resonance condition.

Figure 9B is a bar chart plot of yield in percent against waveguide width w in micrometers for the same batch of devices as shown in Figure 9A. The yield is high away from the resonance condition (correlating with the low threshold current density devices of Figure 9A) whereas the yield is zero or extremely low close to the resonance condition, corresponding to no or hardly any functioning devices being fabricated when the waveguide width is poorly chosen. Yields at or above about 80% were achieved in a range of waveguide widths closest to the off-resonance condition.

### Non-radiative mode perturbation

Figure 10 is a schematic drawing of one example of how the lateral grating can be phase shifted to form an output coupler for the laser. The lateral grating is provided with equal and opposite phase shifts *φ* equal to one quarter of the grating period (or *π*/2 and -*π*/2 in phase space), the locations of the two phase shifts being offset from each other around the ring by an angle *ϕ*.

Provided that the emission arc angle *ϕ* between the two phase shifts is not too large, the cavity mode will prefer to be in the non-radiative mode for the larger angular portion of the ring cavity and in the radiative mode in the smaller angular portion between the two phase shifts.

The emission arc angle *ϕ* is smaller than *π* (180°). The emission arc angle *ϕ* is preferably less than or equal to *π*/2 (90°), and still more preferably less than or equal to *π*/4 (45°), and yet still more preferably less than or equal to *π*/6 (30°).

The scattered field is shown in gray scale and can be seen to be much increased within the emission arc angle *ϕ*. The reason why the provision of equal and opposite phase shifts around a relatively small angular portion of the ring induces efficient outcoupling can be explained by the fact that the non-radiative mode and the radiative mode have different phase alignment (or symmetry) with respect to the teeth of the lateral grating. Namely, the two modes are spatially shifted with respect to the grating teeth by one quarter of the grating period (or *π*/2 in phase space).

Each phase shift may take place at a single "tooth" of the grating or can be distributed over several grating "teeth", i.e., several grating periods.

Figures 11A and 11B are SEM images showing an example of positive and negative *π*/2 phase shifts which are distributed over two grating teeth.

Figures 12A and 12B show simulation results illustrating how the radiative and non-radiative modes are spatially shifted with respect to the grating teeth by one quarter of the grating period (or *π*/2 in phase space). The shading shows electric field strength. The non-radiative mode is illustrated in Figure 12A and the radiative mode is illustrated in Figure 12B. Figure 12A also marks the corrugation depth *d_{g}* of the lateral grating which is the physical depth of the grating teeth in the radial direction as produced by the etch.

The amount of scattering loss can be tuned by increasing or decreasing the emission arc angle *ϕ* between the locations of the equal and opposite *π*/2 phase shifts around the ring, thereby tuning the proportion of laser light propagating in the ring cavity that is coupled out, analogous to tuning the reflectivity of an output coupler mirror in a classic free-space linear cavity laser.

It will be understood that the lateral grating may be formed on the inner and outer sidewalls, or on only the outer sidewall, or on only the inner sidewall.

The amount of scattering loss can also be tuned by moving the magnitude of the equal and opposite phase shifts away from *φ* = *π*/2 (90 degrees), since the scattering loss scales with the magnitude of the phase shift. Maximum scattering loss is achieved at *φ* = *π*/2 and this reduces following a sinusoidal function as one moves away from this maximum, e.g., scattering loss is reduced by half by shifting *π*/3 (60 degrees) away from the peak at *φ* = *π*/2. The magnitude of the equal and opposite phase shifts can thus be selected to be almost any desired value depending on the strength of the output coupling per unit length of the emission arc that is needed.

Figure 13A is a plan view showing the light fields for a semiconductor ring laser as illustrated in Figure 10 as calculated by a numerical simulation, and Figure 13B is an enlarged view of Figure 13A. The light fields show not only the modes as existing within the ring waveguide but also the light that is coupled out of the ring waveguide within the emission arc. As in Figure 10, the semiconductor ring laser has a lateral grating formed on the outer sidewall (and no lateral grating on the inner sidewall, and no top grating). Figure 13B is an enlarged view of the phase shifted arcuate portion of the ring waveguide defined by the angle *ϕ* with the positions of the +*π*/2 and the -*π*/2 phase shifts marked with the solid arrows. As can be seen by looking carefully at Figure 13B, the phase of the grating is shifted by quarter of a grating period (i.e. by *π*/2 in phase space) within the emission arc compared with outside the emission arc. Within the emission arc the nodes and antinodes of the field strength align with the grating teeth whereas outside the emission arc the nodes and antinodes of the field strength are spatially shifted by a quarter of a period. This alignment and quarter-period offset from alignment being indicative of the fact that the cavity mode within the emission arc is the symmetric (radiative) mode whereas the cavity mode outside the emission arc is the antisymmetric (non-radiative) mode. As can be seen in the enlarged view of Figure 13B, light is coupled out of the ring waveguide mostly within the emission arc. The outcoupled light is emitted predominantly in the plane of the chip surface but with some divergence in a direction perpendicular to the ring plane, not dissimilar to the characteristics of the output beam from a conventional edge-emitting laser diode.

### Example results

Three batches of QCLs were fabricated according to the invention, specifically as shown in Figure 3, as well as three corresponding batches according to the prior art design approach, specifically as shown in Figure 1B. These may be referred to as half-sided metallization and double-sided metallization of the ring waveguide ridge. The three batches of inventive examples and comparative examples all have in common that they have a lateral grating formed on the outer sidewall (and no lateral grating on the inner sidewall, and no top grating). It is noted however that the inventive examples and also the comparative examples did not incorporate a phase shift in the lateral grating. This was so that the threshold current density, absent additional losses intentionally introduced by the grating coupling to the lateral cavity, should be equal to a ring cavity without a grating which essentially supports only the non-radiative mode with no outcoupling of laser light. In other words, none of these example lasers have an output coupler feature. The three batches of inventive examples and comparative examples differ in the corrugation depth of the lateral grating. The inventive and comparative first batches have a corrugation depth *d_{g}* of 0.6 µm. The inventive and comparative second batches have a corrugation depth *d_{g}* of 0.9 µm. The inventive and comparative third batches have a corrugation depth *d_{g}* of 1.2 µm. Grating strength increases with increasing corrugation depth, so deeper corrugations are expected to cause stronger coupling to lateral cavity modes.

Figures 14A and 14B are box plots indicating the relative performance of the different lasers in plots of lasing threshold current density *Iₜₕ* in units of *kA*/*cm*² for each of the three corrugation depths. The box plots show the median with the dot-dashed line. The box is delimited by first and third quartile (Q1 and Q3) and the whiskers extend to Q1-1.5*IQR and Q3+1.5*IQR, where IQR=Q3-Q1. Outliers are anything beyond Q1-1.5*IQR or Q3+1.5*IQR. The outliers are marked with the empty circles. The solid circles to the left side of each boxplot have been distributed over a finite distribution on the x axis in order that their distribution can be visually appreciated, even though all the solid circles in each group have the same value of corrugation depth (*d_{g}* = 0.6, 0.9 or 1.2 µm). Figure 14A shows the three batches of comparative examples. Figure 14B shows the three batches of inventive examples. Each dot represents an individual laser device. Any non-functioning device, i.e., any device that did not lase at all, is absent from the plot, since it was not able to attain threshold. The flat dashed line in each plot indicates the threshold current density of a batch of ring laser devices fabricated with no grating, representing ideal ring cavities, the values being approximately 1.35 *kA*/*cm*².

Threshold current density was chosen as the parameter to plot, since it is a good overall indicator of device quality of a laser. Absent intentional scattering losses for outcoupling, threshold current density should be low, since this indicates low losses, such as low internal losses and low cavity losses. Moreover, for a given batch of lasers that are manufactured, e.g., from the same wafer, uniformity of performance of the individual lasers, such as a narrow spread of threshold current densities, is also an indicator of quality, since that will indicate the fabrication processes are consistent and will also correlate with yield, since a wider statistical spread of performance will usually be associated with a lower yield, since more of the devices will not meet specification and will need to be discarded.

Referring to the results for the comparative examples in Figure 14A, it can be seen that the 0.6 µm comparative batch has threshold current densities closely clustered around *1.6 kA*/*cm*², which compares with the value of 1.35 *kA*/*cm*² for the ideal ring cavity (dashed line). The 0.9 µm comparative batch has significantly higher threshold current densities around approximately 2.0 *kA*/*cm*² indicating a reduction in efficiency as well as a somewhat increased spread in performance. The 1.2 µm comparative batch is a generally poor batch in that the threshold current densities are scattered over a large range and also a significant number of the devices did not lase at all. The threshold current of the three comparative batches therefore increases with increasing corrugation depth, which is an indicator of the presence of unwanted losses caused by the metal layer.

Referring to the results for the inventive examples in Figure 14B, it can be seen that all three batches have very similar characteristics in terms of threshold current density. All three inventive batches have threshold current densities closely clustered around approximately *1.4 kA*/*cm*² , very close to the value of 1.35 *kA*/*cm*² for the ideal ring cavity (dashed line), and all three batches show a narrow spread in threshold current density.

It is therefore concluded that the increase in threshold current density with corrugation depth in the comparative example devices is caused by fabrication imperfections that lead to significant coupling to the radiative mode, whose losses are enhanced by the lateral optical cavity formed between the metal layers on the inner and outer sidewalls. By comparison, the inventive example devices are much more resilient to fabrication imperfections and have threshold current densities close to the ideal value for all three corrugation depths.

### Ways to achieve perturbation of the non-radiative mode

Figures 15A to 15D are schematic plan views of example semiconductor ring lasers according to different embodiments of the invention with different designs for the output coupling.

Figure 15A is a semiconductor ring laser 1 according to an embodiment of the invention as described above. A ridge 12 extends in a closed loop, illustrated as circular. The ridge 12 is defined by an inner sidewall 14, an outer sidewall 16 and a top surface 18. A lateral grating is integrated with the outer sidewall 16 and has a single period around the loop. The lateral grating is subdivided into major and minor arcuate sections, functioning as a mode selecting grating 32 and an output coupling grating 34 respectively, whose azimuthal mode numbers are the same, i.e., *m*₁ = *m*₂*.* The major and minor arcuate sections are separated by first and second grating transitions 38, 40 that provide equal and opposite phase shifts (offsets). As discussed above, maximum scattering loss is induced when the phase shifts have a magnitude of a quarter of the grating period (i.e., ±90°). The magnitude of the phase shift can however be set at a value away from this maximum, for example if a lower amount of scattering is desired. The minor arcuate section that accommodates the output coupling grating 34 forms an emission arc extending over an angle *ϕ*. Alternatively, the mode selecting grating 32 and the output coupling grating 34 could be formed on the inner sidewall 14, or on both the inner and outer sidewalls 14, 16.

Figure 15B is a semiconductor ring laser 1 according to another embodiment of the invention with a different design of the output coupler. A ridge 12 extends in a closed loop, illustrated as circular. The ridge 12 is defined by an inner sidewall 14, an outer sidewall 16 and a top surface 18. A lateral grating is integrated with the outer sidewall 16. The lateral grating is subdivided into major and minor arcuate sections, functioning as a mode selecting grating 32 and an output coupling grating 34 respectively, whose periods are different and whose azimuthal mode numbers are also different, i.e., *m*₁ *= m*₂.. The major and minor arcuate sections are separated by first and second grating transitions 38, 40. The change in period and azimuthal mode number promotes the lateral output coupling within the emission arc of angle *ϕ*. Figure 15B is an example design showing how the output coupler may be formed by providing a different grating pitch within the emission arc. The grating period is changed within the emission arc to one associated with a different azimuthal mode number. The change of the azimuthal mode number between the emission arc and the remainder of the ring causes the laser to operate in a superposition of the non-radiative and radiative modes within the emission arc of angle *ϕ*. In more detail, the standing wave pattern of the electric field in the ring cavity will be dominated by the non-radiative mode of the mode selecting grating outside the emission arc, whereas, within the emission arc, the modified period of the output coupling grating will cause a periodic beating to take place between the radiative and non-radiative mode. To cover a full beating period, the angle of the emission arc *ϕ* needs to be 2*π*/Δ*m,* where Δ*m* = |*m*₁ - *m*₂|, i.e., the difference in azimuthal mode number between the mode selecting grating and the output coupling grating. However, it is not necessary to cover a full beating period. It may be enough to cover half a period *ϕ* = *π*/Δ*m* or a quarter of a period *ϕ* = *π*/2Δ*m*, for example. This may be the case if a weaker output coupling effect is preferred. Compared to embodiments that use equal and opposite phase shifts of *π*/2 to promote output coupling, changing the grating period only produces approximately half the losses (and hence outcoupling efficiency) per unit angle. The above comments on the preferred values of emission arc angle *ϕ* also apply to this design option. Alternatively, the lateral grating could be formed on the inner sidewall 14, or on both the inner and outer sidewalls 14, 16.

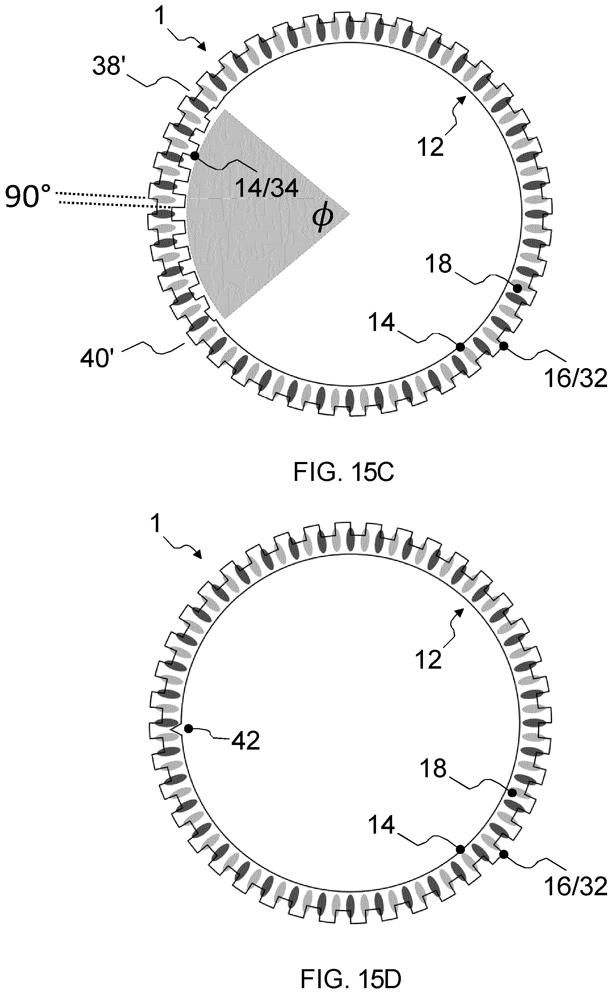

Figure 15C is a semiconductor ring laser 1 according to another embodiment of the invention with a further design of the output coupler. A ridge 12 extends in a closed loop, illustrated as circular. The ridge 12 is defined by an inner sidewall 14, an outer sidewall 16 and a top surface 18. A first lateral grating is integrated with the outer sidewall 16 to function as a mode selecting grating 32 and extends around the whole loop. A second lateral grating is integrated with the inner sidewall 14 to function as an output coupling grating 34 and extends around a minor arcuate section of the loop to form an emission arc of angle *ϕ*. The mode selecting grating 32 is thus formed on the outer sidewall 16 and extends around the full loop, and the output coupling grating 34 is formed on the inner sidewall 14 and extends over a minor arcuate section of the loop bounded by first and second ends 38', 40'. Similar to the design of Figure 15A, the output coupling is induced by a quarter period phase offset between the mode selecting grating 32 and the output coupling grating 34, and, also similar to the design of Figure 15A, the mode selecting grating 32 and the output coupling grating 34 have the same period and support the same azimuthal mode numbers, i.e., *m*₁ = *m*₂. Figure 15C is an example design showing how the output coupler may be formed by combining a uniform pitch lateral grating around the whole ring on one sidewall and a phase shifted lateral grating limited to an emission arc of angle *ϕ* on the other sidewall. Alternatively, the inner and outer sidewalls can be switched. The above comments on the preferred values of emission arc angle *ϕ* also apply to this design option.

Figure 15D is a semiconductor ring laser 1 according to another embodiment of the invention with a still further design of the output coupler. A ridge 12 extends in a closed loop, illustrated as circular. The ridge 12 is defined by an inner sidewall 14, an outer sidewall 16 and a top surface 18. A lateral grating is integrated with the outer sidewall 16 and has a single period around the loop to form a mode selecting grating 32. The lateral grating 30 is continuous around the loop without any transitions in phase or period. Output coupling is instead provided by a point scatterer in the form of a notch 42 etched laterally into the inner sidewall. A lateral emission of laser light localized around the notch 42 then arises. Figure 15D is an example design showing how the output coupler may be formed by a point scattering feature arranged on a sidewall of the ridge. Alternatively, the lateral grating could be formed on the inner sidewall, or the inner and outer sidewalls, and the point scattering feature could be formed on either sidewall.

While the examples of Figures 15A to 15D have in common that there is only one output coupler, it would be possible to provide more than one output coupler, for example two output couplers, arranged at different angular positions in the ring, for example on opposite sides of the ring. In the case of an output coupling grating, the grating would then have multiple non-contiguous grating sections. In the case of an output coupler point scatterer, there would then be multiple point scatterers, for example multiple notches. The mode-selecting grating may then be split into two or more separate sections by the presence of a plurality of output couplers. Moreover, even in examples with only one output coupler, the mode-selecting grating may be split into two or more separate sections. In these examples with multiple output coupling gratings and/or a multi-section mode selecting grating, the azimuthal angles as discussed elsewhere in this document can be understood as aggregate angles made up of the sum of the contributions from the different sections of mode-selecting grating and/or output coupling grating.

In summary, the above-described examples of Figures 15A to 15D explain how there are several options for perturbing the non-radiative mode over a limited length portion of the ring and thereby induce the cavity mode to change in that limited angular range from the non-radiative mode into a mode which is either essentially entirely the radiative mode or a mode that is mixed between non-radiative and radiative components with a sizeable radiative component.

It will be clear to one skilled in the art that many improvements and modifications can be made to the foregoing exemplary embodiment without departing from the scope of the present disclosure.

### REFERENCE NUMERALS

- 1: ring laser
- 10: epitaxial layers
- 12: ridge
- 13: etched planar surface
- 14: inner sidewall
- 16: outer sidewall
- 18: top surface
- 19: elevated planar surface
- 20: active region layers
- 22: passivation layer of dielectric material
- 24: metal layer
- 25: trench
- 26: planarizing layer of polymer
- 30: lateral grating
- 30': further lateral grating
- 32: mode selecting grating
- 34: output coupling grating
- 36: phase shifted angular portion
- 38: first grating transition
- 38': first grating end
- 40: second grating transition
- 40': second grating end
- 42: output coupling notch

## Claims

1. A semiconductor ring laser (1) comprising:
a ring waveguide formed of a ridge (12) of semiconductor material having an inner sidewall (14) and an outer sidewall (16);
a mode selecting grating (32) arranged on at least one of the inner and outer sidewalls (14, 16) to define a ring cavity that supports a radiative and a non-radiative mode, the non-radiative mode having lower losses than the radiative mode so that the non-radiative mode becomes the lasing mode; and
an output coupler (34; 42) arranged on at least one of the inner and outer sidewalls (14, 16) and configured such that local to the output coupler (34; 42) the non-radiative mode that is the lasing mode is forced into a radiative mode, or a mixed radiative and non-radiative mode, thereby to couple laser light out of the ring waveguide through at least one of the inner and outer sidewalls (14, 16).

2. A laser according to claim 1, wherein the output coupler comprises an output coupling grating (34).

3. A laser according to claim 2, wherein the output coupling grating (34) and the mode selecting grating (32) have a common period and respective first and second azimuthal mode numbers, denoted *m*₁, *m*₂, that are equal, and wherein the output coupling grating (34) and the mode selecting grating (32) have a phase offset.

4. A laser according to claim 3, wherein the phase offset approximates to a quarter of the common period, i.e., 90 degrees (*π*/2), in a range selected from the group:
90±80 degrees;
90±70 degrees;
90±60 degrees;
90±50 degrees;
90±40 degrees; and
90±30 degrees.

5. A laser according to claim 2, wherein the mode selecting grating (32) and the output coupling grating (34) have respective first and second periods that are different from one another as well as respective first and second azimuthal mode numbers, denoted *m*₁, *m*₂, that are different from one another.

6. A laser according to claim 5, wherein the output coupling grating (34) extends over an angle *ϕ* that is related to the difference between the first and second azimuthal mode numbers, denoted Δ*m* = |*m*₁ - *m*₂|, such that the product Δ*m* · *ϕ* is selected from the group:
greater than or equal to 360 degrees (2*π*);
greater than or equal to 180 degrees (*π*); and
greater than or equal to 90 degrees (*π*/2).

7. A laser according to any one of claims 2 to 6, wherein the output coupling grating (34) extends over an angle *ϕ* selected from the group:
less than or equal to 90 degrees (*π*/2);
less than or equal to 45 degrees (*π*/4); and
less than or equal to 30 degrees (*π*/6).

8. A laser according to claim 1, wherein the output coupler comprises a point scatterer (42).

9. A laser according to any one of claims 1 to 8, wherein the ridge (12) further comprises a top surface (18), and wherein the semiconductor ring laser further comprises a metal layer (24) arranged to cover the top surface (18) where it forms an ohmic contact, the metal layer (24) being further arranged to cover one and only one of the inner and outer sidewalls (14, 16) thereby providing a metallized sidewall and an unmetallized sidewall.

10. A laser according to claim 9, wherein the ring waveguide has a width selected such that the phase delay accumulated between laser light coupled out of the ring waveguide through the unmetallized sidewall (14, 16) indirectly via reflection from the metallized sidewall (16, 14) and laser light coupled out of the ring waveguide through the unmetallized sidewall directly without reflection from the metallized sidewall is in a range selected from the group: $2 π ⋅ \left(k\pm \frac{1}{3}\right) ;$ $2 π ⋅ \left(k\pm \frac{1}{4}\right) ;$ and $2 π ⋅ \left(k\pm \frac{1}{6}\right) ,$ where k is a positive integer, thereby ensuring that laser light coupled out directly and indirectly via said reflection constructively interfere with each other.

11. A laser according to claim 9 or claim 10, wherein the metal layer (24) covers the inner sidewall (14), there being a layer of dielectric material (22) interposed between the inner sidewall (14) and the metal layer (24) and, optionally also, the outer sidewall (16) is covered with a layer of the dielectric material (22), which is in turn exposed to air, and the mode selecting grating (32) and the output coupling grating (34) are either arranged on at least the outer sidewall (16) or on at least on the inner sidewall (14).

12. A laser according to any one of claims 1 to 8, wherein the ridge (12) further comprises a top surface (18), and wherein the semiconductor ring laser further comprises a metal layer (24) arranged to cover the top surface (18) where it forms an ohmic contact, the metal layer (24) being further arranged to cover both the inner and outer sidewalls (14, 16), so that the metal layer (24) forms a lateral optical cavity between the inner and outer sidewalls (14, 16), wherein the ring waveguide has a width selected such that the phase delay accumulated by laser light scattered by the output coupler (34; 42) and reflected from the inner and outer sidewalls (14, 16) is in a range selected from the group: $2 π \left(k+\frac{1}{2}\pm \frac{1}{3}\right) ;$ $2 π \left(k+\frac{1}{2}\pm \frac{1}{4}\right) ;$ and $2 π \left(k+\frac{1}{2}\pm \frac{1}{6}\right) ,$ where k is a positive integer, thereby avoiding that the lasing mode resonates with a mode of the lateral optical cavity.

13. A laser according to any one of claims 1 to 8, wherein the ridge (12) further comprises a top surface (18), and wherein the semiconductor ring laser further comprises a metal layer (24) arranged to cover the top surface (18) where it forms an ohmic contact, the metal layer (24) being further arranged so it neither covers the inner nor the outer sidewall (14, 16), thereby avoiding that the metal layer (24) forms a lateral optical cavity between the inner and outer sidewalls (14, 16).

14. A method of manufacturing a semiconductor ring laser (1), the method comprising:
fabricating a semiconductor heterostructure by:
i. providing a substrate;
ii. depositing lower semiconductor layers including at least one lower waveguiding layer;
iii. depositing active region layers by alternating deposition of first and second semiconductor materials having different values of band gap energy to form a multi-quantum well structure or a superlattice; and
iv. depositing upper semiconductor layers including at least one upper waveguiding layer;
performing an etch to create a ring waveguide by removing selected areas of the semiconductor heterostructure to a depth extending through the upper semiconductor layers and the active region layers to form a ridge (12) having an inner sidewall (14), an outer sidewall (16) and a top surface (18),
wherein the etch also creates corrugations in at least one of the inner and outer sidewalls (14, 16), the corrugations creating a mode selecting grating (32) to define a ring cavity that supports a radiative and a non-radiative mode, the non-radiative mode having lower losses than the radiative mode so that the non-radiative mode becomes the lasing mode, and
wherein the etch also creates an output coupler (34; 42) arranged laterally on at least one of the inner and outer sidewalls such that local to the output coupler the non-radiative mode that is the lasing mode is forced into a radiative mode, or a mixed radiative and non-radiative mode, thereby to couple laser light out of the ring waveguide through at least one of the inner and outer sidewalls (14, 16).

15. **The** method of claim 21, wherein the etch also creates further corrugations in at least one of the inner and outer sidewalls, the further corrugations creating the output coupler as an output coupling grating (34), or also creates a notch (42) in at least one of the inner and outer sidewalls, the notch creating the output coupler as a point scatterer.
